(19) Europäisches Patentamt
European Patent Office
Office européen des brevets

(11) **EP 2 029 399 B1**

(12) **FASCICULE DE BREVET EUROPEEN**

(45) Date de publication et mention
de la délivrance du brevet:
**13.04.2016 Bulletin 2016/15**

(21) Numéro de dépôt: **07788905.3**

(22) Date de dépôt: **19.06.2007**

(51) Int Cl.:
***G01R 31/311*** *(2006.01)*

(86) Numéro de dépôt international:
**PCT/FR2007/001014**

(87) Numéro de publication internationale:
**WO 2007/147968 (27.12.2007 Gazette 2007/52)**

(54) **PROCEDE D'ANALYSE D'UN CIRCUIT INTEGRE, PROCEDE D'OBSERVATION ET LEURS INSTALLATIONS ASSOCIEES**

VERFAHREN ZUR ANALYSE EINER INTEGRIERTEN SCHALTUNG, BEOBACHTUNGSVERFAHREN UND ENTSPRECHENDE INSTALLATIONEN

METHOD OF ANALYSING AN INTEGRATED CIRCUIT, METHOD OF OBSERVATION AND THEIR ASSOCIATED INSTALLATIONS

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **19.06.2006 FR 0605435**

(43) Date de publication de la demande:
**04.03.2009 Bulletin 2009/10**

(73) Titulaire: **Centre National d'Etudes Spatiales (C.N.E.S.)**
**75001 Paris (FR)**

(72) Inventeurs:
• **DESPLATS, Romain**
**F-31320 Castanet Tolosan (FR)**
• **SANCHEZ, Kevin**
**F-31400 Toulouse (FR)**

(74) Mandataire: **Blot, Philippe Robert Emile**
**Cabinet Lavoix**
**2, place d'Estienne d'Orves**
**75441 Paris Cedex 09 (FR)**

(56) Documents cités:
**FR-A1- 2 876 188**

**Description**

La présente invention concerne un procédé d'analyse d'un circuit intégré.

Les circuits intégrés fonctionnent à grande vitesse et la moindre faiblesse interne risque de mettre leur fonctionnement global en défaillance. Dans le cas de circuits utilisés dans des environnements particulièrement contraints, tels que rencontrés lors de missions spatiales, l'environnement radiatif ou les contraintes de température par exemple aggravent la sensibilité aux faiblesses ou aux petits défauts internes.

Pour déterminer les faiblesses des circuits intégrés, il est connu de soumettre ceux-ci à un rayonnement laser local et d'évaluer le fonctionnement du circuit sous une telle contrainte.

En particulier, il est connu d'exciter le circuit avec un signal électrique d'entrée alors que celui-ci est soumis à un rayonnement laser et de vérifier que le résultat obtenu en sortie du circuit est correct. Le laser est appliqué sur une zone réduite du circuit intégré et le test est répété pour plusieurs positions du laser sur la surface du circuit, de manière à balayer l'ensemble du circuit et ainsi créer une cartographie du circuit permettant de repérer les zones qui, lorsqu'elles sont soumises à un rayonnement laser, conduisent à ce que le circuit produise en sortie un résultat non conforme.

Un tel procédé est décrit, par exemple, dans le document US 6,483,322 et le document US-4,698,587.

Ces procédés d'analyse sont relativement efficaces mais ne permettent que la détection de défauts significatifs dans le circuit qui, lorsqu'ils sont soumis à un rayonnement laser, conduit à un dysfonctionnement visible du circuit, en ce sens qu'il ne fournit pas le résultat escompté.

Par ailleurs, il est connu du document FR 2 876 188 un procédé et une installation d'analyse d'un circuit intégré permettant de calculer une variation du temps de propagation du signal au travers du circuit séparant l'instant d'excitation électrique du circuit de l'instant de recueil de la réponse en présence et en l'absence de rayonnement laser. Cette méthode permettant une cartographie des retards de propagation induits par la présence du laser donne des résultats excellents sur l'analyse et la caractérisation de circuits défaillants. Cependant, ce procédé et cette installation nécessitent des mesures numériques très précises du retard. Cette mesure peut dans certains cas, devoir être inférieure à la dizaine de picosecondes, ce qui rend la mesure extrêmement délicate à réaliser.

Ainsi, l'invention a pour but de proposer un procédé d'analyse et une installation d'analyse d'un circuit permettant de mesurer plus facilement l'incidence d'un faisceau laser sur le circuit en fonctionnement.

A cet effet, l'invention a pour objet un procédé d'analyse d'un .circuit intégré, comportant :

- une étape d'application d'un rayonnement laser en un point de la surface du circuit ;
- une étape d'excitation du circuit ainsi soumis au rayonnement laser par application d'un signal électrique d'excitation ;
- une étape de recueil de la réponse du circuit à l'excitation soumis au rayonnement laser ;
- une étape de mesure de la différence de phase entre la réponse à l'excitation du circuit soumis au rayonnement laser, et une réponse de référence du circuit en l'absence de rayonnement laser appliqué au circuit.

Suivant des modes particuliers de mise en oeuvre, le procédé d'analyse comporte l'une ou plusieurs des caractéristiques suivantes :

- la réponse de référence est le signal d'excitation du circuit décalé temporairement par rapport à la réponse du circuit soumis au rayonnement laser d'un retard égale au temps de propagation du signal d'excitation au travers du circuit en l'absence de rayonnement laser ;
- la réponse de référence est un signal qui est fonction de la réponse attendue en sortie du circuit en l'absence de rayonnement laser ;
- la réponse de référence est égale à la réponse attendue en sortie du circuit fonctionnant normalement en l'absence de rayonnement ;
- la réponse de référence est une transformée de la réponse attendue en sortie du circuit en l'absence de rayonnement, de même fréquence et dont l'amplitude et/ ou la largeur des impulsions et/ ou la forme des impulsions ont été modifiées ;
- l'étape de mesure du déphasage entre la réponse à l'excitation du circuit soumis au rayonnement laser et une réponse de référence du circuit en l'absence de rayonnement laser appliqué au circuit comprend :

  - la multiplication de la réponse à l'excitation du circuit soumis au rayonnement laser par la réponse de référence du circuit en l'absence de rayonnement laser appliqué au circuit ; et

  - la filtration du produit obtenu par un filtre passe bas ;

L'invention a également pour objet un procédé d'observation, caractérisé en ce qu'il comporte :

- pour une pluralité de points à la surface du circuit intégré, une étape d'analyse du circuit telle que décrite ci-dessus pour la détermination de la différence de phase entre la réponse à l'excitation du circuit soumis au rayonnement laser en un point de la surface du circuit intégré et une réponse de référence du circuit en l'absence de rayonnement laser appliqué au circuit ; et

- une étape de création d'une image du circuit intégré illustrant une valeur représentative de la différence de phase entre la réponse à l'excitation du circuit soumis au rayonnement laser et la réponse de référence du circuit en l'absence de rayonnement laser appliqué au circuit pour chaque point d'application du rayonnement laser ;

  - le rayonnement laser a une longueur d'onde comprise entre 800 nm et 1400 nm ;
  - la longueur d'onde du rayonnement laser est choisie dans le groupe consistant en 1064 nm et 1340 nm ;
  - le rayonnement laser est appliqué en chaque point de manière synchrone avec l'étape d'excitation du circuit ;
  - le rayonnement laser est appliqué en chaque point de manière asynchrone avec l'étape d'excitation du circuit ; et
  - le rayonnement laser est pulsé avec au moins une impulsion en chaque point du circuit.

L'invention a également pour objet une installation d'analyse d'un circuit intégré, comportant :

  - des moyens d'application d'un rayonnement laser en un point de la surface du circuit ;
  - des moyens d'excitation du circuit ainsi soumis au rayonnement laser par application d'un signal électrique d'excitation ;
  - des moyens de recueil de la réponse du circuit à l'excitation soumis au rayonnement laser ;
  - des moyens pour fournir une réponse de référence du circuit en l'absence de rayonnement laser appliqué au circuit ; et
  - des moyens de mesure de la différence de phase entre la réponse à l'excitation du circuit soumis au rayonnement laser, et la réponse de référence du circuit en l'absence de rayonnement laser appliqué au circuit.

L'invention a enfin pour objet une installation d'observation caractérisée en ce qu'elle comporte :

  - pour une pluralité de points à la surface du circuit intégré, des moyens d'analyse du circuit tels que décrits ci-dessus pour la détermination de la différence de phase entre la réponse à l'excitation du circuit soumis au rayonnement laser en un point de la surface du circuit intégré et une réponse de référence du circuit en l'absence de rayonnement laser appliqué au circuit ; et
  - des moyens de création d'une image du circuit intégré illustrant une valeur représentative de la différence de phase entre la réponse à l'excitation du circuit soumis au rayonnement laser, et la réponse de référence du circuit en l'absence de rayonnement laser appliqué au circuit pour chaque point d'application du rayonnement laser.

L'invention sera mieux comprise à la lecture de la description qui va suivre, donnée uniquement à titre d'exemple, et faite en se référant aux dessins, sur lesquels :

  - la figure 1 est une vue schématique d'un premier mode de réalisation d'une installation d'analyse d'un circuit mettant en oeuvre un procédé selon l'invention ;
  - la figure 2 est un organigramme de l'algorithme mis en oeuvre par l'installation de la figure 1 ;
  - les figures 3A, 3B, 3C et 3D sont des courbes illustrant respectivement le signal électrique d'excitation du circuit ; le signal recueilli en sortie du circuit ; le produit des signaux d'excitation et de sortie ; un signal continue (après stabilisation) représentant la différence de phase entre le signal d'excitation retardé et le signal recueilli en sortie du circuit, alors que le circuit fonctionne en l'absence de rayonnement laser ; et
  - les figures 4A, 4B, 4C et 4D d'une part et les figures 5A, 5B, 5C et 5D d'autre part sont des vues identiques à celles des figures 3A, 3B, 3C et 3D respectivement dans le cas où le circuit est sollicité par un laser ayant pour effet un retard temporel du signal de réponse et une avance temporelle du signal de réponse respectivement.
  - la figure 6 est un exemple d'image d'un circuit obtenue par mise en oeuvre du procédé selon l'invention ;
  - la figure 7 est une vue schématique d'un deuxième mode de réalisation d'une installation d'analyse d'un circuit selon l'invention ;
  - la figure 8 est une vue illustrant les courbes du signal de référence utilisé et du signal de réponse du circuit dans le mode de réalisation de la figure 7, et

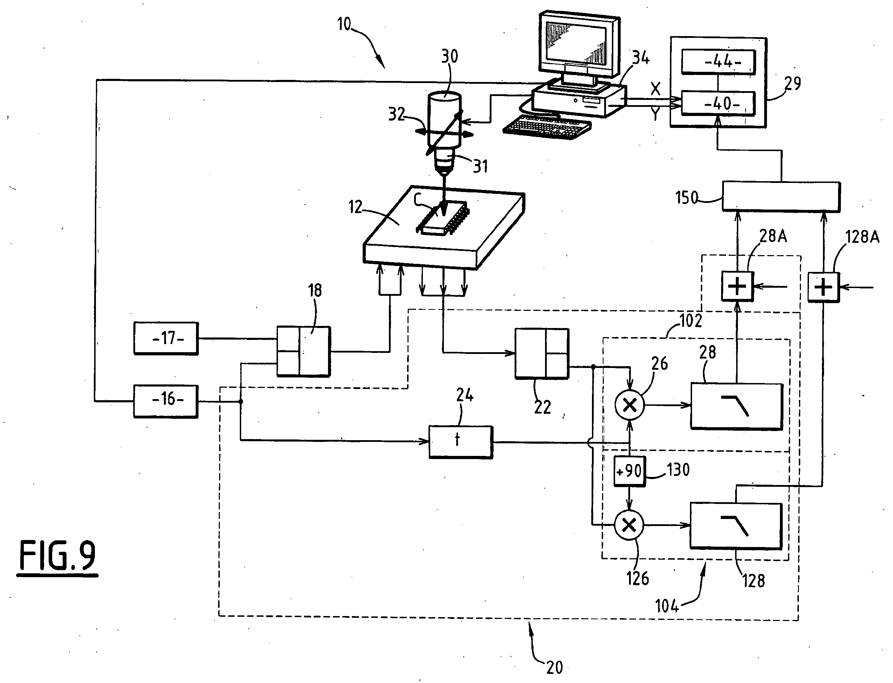

  - la figure 9 est une vue schématique d'un troisième mode de réalisation d'une installation d'analyse d'un circuit selon l'invention.

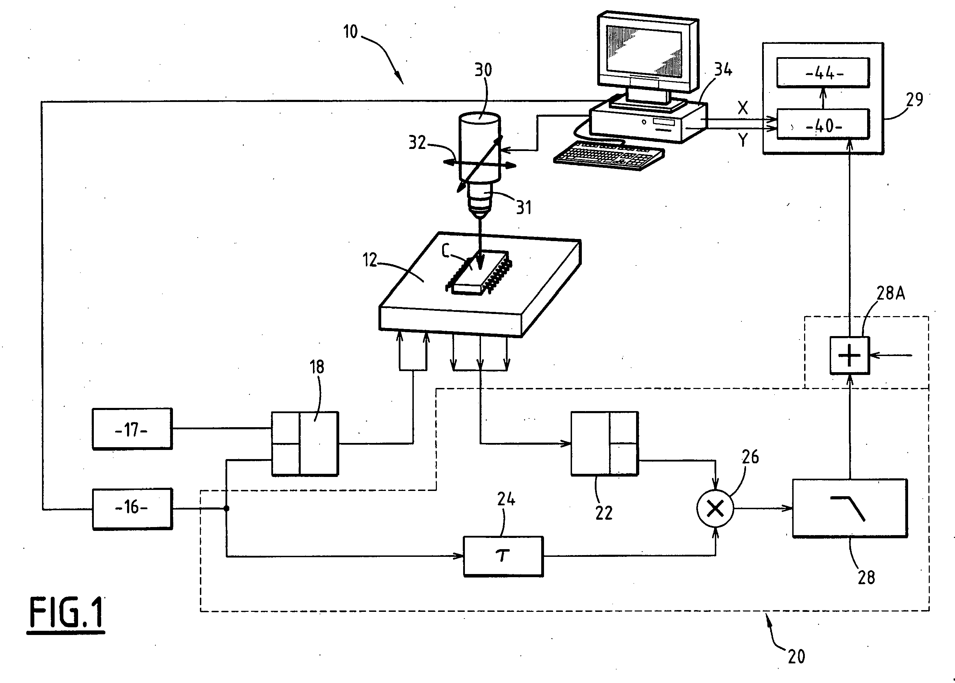

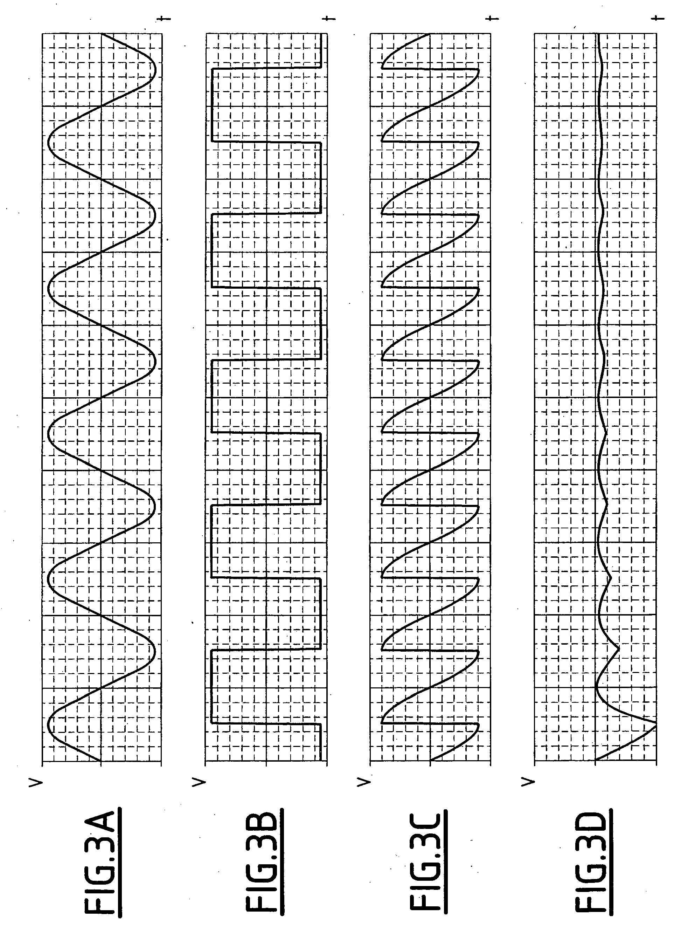

La figure 1 montre une installation 10 d'analyse et d'observation d'un circuit intégré C comportant une platine 12 de réception et de connexion du circuit intégré et un générateur 16 de signaux de test pour l'excitation du circuit. Le générateur 16 de signaux d'excitation est par exemple un générateur de fonction propre à fournir un signal sinusoïdal dont l'amplitude varie entre + 1 volt et - 1 volt à une fréquence déterminée comme illustré sur la figure 3A.

Ce signal d'excitation est par exemple un signal d'horloge pour le circuit C.

L'installation comprend en outre un générateur de tension 17 dont la sortie est reliée à la sortie du générateur de signaux d'excitation 16 pour assurer la sommation des signaux dans une unité de sommation 18 dont la sortie est reliée aux entrées du circuit C au travers de la platine 12 pour fournir un signal d'entrée. Aussi, par exemple, le signal d'entrée en sortie de l'unité de sommation 18 est un signal sinusoïdal dont l'amplitude est comprise entre 0 et + 2 volts.

Au moins une sortie du circuit intégré C est reliée à une unité 20 de mesure de la différence de phase ou déphasage entre le signal d'excitation du circuit C et le signal de sortie de ce circuit comme illustré sur la figure 3B.

L'unité de mesure 20 comporte en entrée une unité 22 de soustraction de la composante continue du signal de sortie constituant la réponse du circuit pour obtenir en sortie un signal alternatif centré sur 0V.

En outre, l'unité 20 comporte une ligne à retard 24 dont l'entrée est reliée en sortie du générateur 16 et est propre à fournir un signal d'excitation retardé d'un retard $\tau$ ajusté pour correspondre à la durée de traitement du signal par le circuit à étudier en l'absence de sollicitation laser. Préférentiellement, le retard $\tau$ est fixé de sorte que le signal retardé de $\tau$ arrive en quadrature avec le signal étudié du circuit lorsque le circuit n'est pas soumis à un rayonnement laser et qu'il fonctionne normalement. Le retard $\tau$ est déterminé expérimentalement et est caractéristique d'un signal de sortie du circuit.

Les sorties de l'unité 22 et de la ligne à retard 24 sont connectées aux entrées d'un circuit multiplicateur 26 dont la sortie est elle-même reliée à un amplificateur avec filtre passe bas 28, dont la fréquence de coupure est ajusté en fonction de la fréquence de fonctionnement du circuit et la vitesse de balayage du laser. Cette fréquence est typiquement de l'ordre de 500 KHz.

La sortie de l'unité 20 est formée par la sortie de l'amplificateur à filtre passe bas 28, lequel est si nécessaire associé à un circuit de décalage 28A pour amener le signal obtenu en sortie du filtre 28 dans une plage positive de valeur pour faciliter son traitement ultérieur, ce signal étant initialement compris dans un intervalle centré sur la valeur nulle.

La sortie du filtre 28, est reliée à une unité de traitement d'informations 29, constituée par exemple d'un ordinateur équipé d'une carte d'acquisition.

Par ailleurs, l'installation 10 comporte une source laser 30 disposée au droit du circuit à tester et sur lequel un objectif 31 est monté. La source laser 30 est portée par des moyens 32 de déplacement du faisceau laser dans le plan du circuit suivant deux directions perpendiculaires l'une à l'autre.

Les moyens de déplacement 32 sont reliés à une unité de pilotage 34 propre à commander la position du laser et à commander le déclenchement de celui-ci.

L'unité de pilotage 34 est formée par exemple d'un ordinateur associé à des moyens de commande.

En outre, l'unité de pilotage 34 est reliée à l'unité de génération de signaux d'excitation de test 16 pour déclencher l'excitation du circuit de manière synchronisée avec l'illumination locale du circuit depuis le laser 30.

Suivant un mode de réalisation, le faisceau laser a une longueur d'onde supérieure à 1100 nm et de préférence égale à 1340 nm et est propre à induire un effet thermique dans le matériau semi-conducteur propre à modifier sa résistivité locale.

Suivant un autre mode de réalisation, le faisceau laser a une longueur d'onde inférieure à 1100 nm, de préférence comprise entre 800 nm et 1100 nm et est propre à induire des phénomènes photoélectriques dans le matériau du circuit.

Par ailleurs, le laser a une longueur d'onde comprise entre 1000 nm et 1400 nm lorsqu'il traverse une couche de silicium. La transparence du silicium à ces longueurs d'ondes permet de réaliser des analyses au travers du substrat, sans être écranté par les couches métalliques distribuées sur la surface du circuit.

En particulier, lorsque des phénomènes photoélectriques sont mis en évidence et que le laser traverse une couche de silicium, le laser présente de préférence une longueur d'onde de 1064 nm, de manière à permettre que le rayonnement laser induise la création de paires électrons-trous dans le semi-conducteur formant le circuit, ces paires électrons-trous donnant naissance à la circulation d'un courant.

Le faisceau laser présente une distribution gaussienne, lorsqu'il a atteint sa limite de résolution.

L'unité de pilotage 34 est reliée à l'unité de traitement d'information 29 pour fournir les coordonnées X et Y du faisceau laser dans le plan du circuit, ces coordonnées étant représentatives de la position du point d'impact du faisceau laser sur le circuit.

L'unité de traitement d'information 29 comporte une unité 40 de stockage en temps réel propre à mémoriser, lors de chaque test effectué sur le circuit, les positions X, Y du point d'impact du faisceau laser, ainsi que le déphase $\Phi$ entre le signal d'excitation du circuit et la réponse en sortie du circuit soumis à un rayonnement laser. Ces moyens de stockage sont propres à recevoir ces informations à un rythme très élevé lorsqu'elles sont déterminées par l'unité 20.

Les moyens de stockage 40 sont ainsi propres à mémoriser les triplets (X, Y, $\phi$) pour tous les points du circuit. Ils sont reliés en sortie à des moyens de création 44 d'une image du circuit, cette image représentant les valeurs de déphasage résultant de la présence du faisceau laser suivant toute la surface du circuit.

La création 44 d'une image du circuit peut se faire point par point de manière synchrone avec le balayage du laser, l'unité de traitement d'information transformant la valeur du déphasage $\phi$ (mesure en tension) en un niveau de couleur du pixel sur l'image.

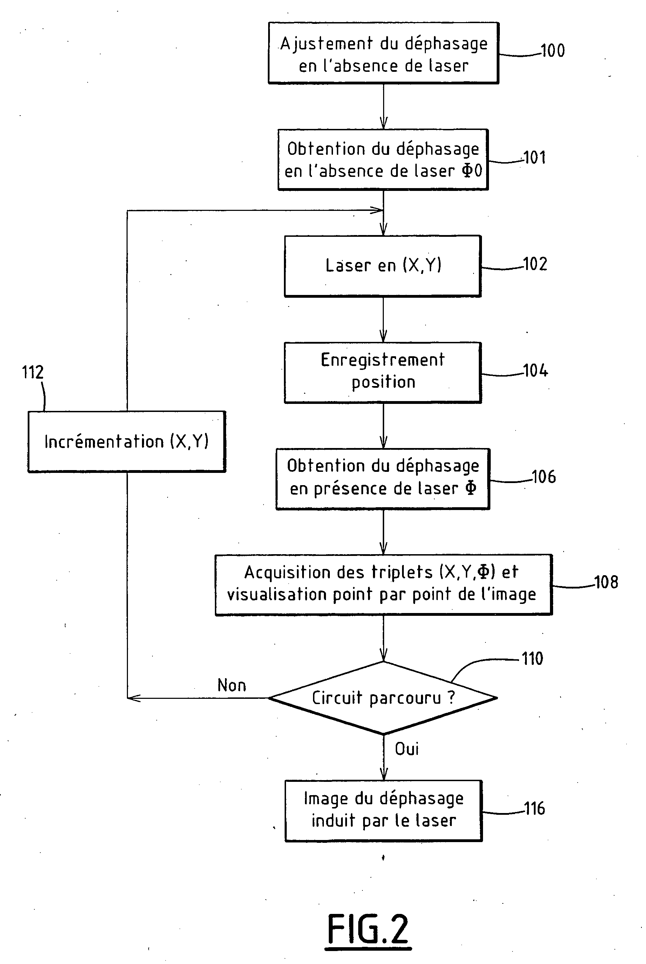

L'installation de la figure 1 est propre à mettre en oeuvre l'algorithme illustré sur la figure 2.

Initialement, à l'étape 100, aucun rayonnement laser n'est appliqué sur le circuit. Le signal d'entrée met un temps de propagation $\tau p$ de référence pour se propager au travers du circuit. Le déphasage $\Phi_0$ entre ce signal venant du circuit et le signal de référence traversant la ligne à retard 24 est alors ajusté en jouant sur la valeur $\tau$ du retard.

L'ajustement de la valeur du retard peut se faire par exemple avec une approche par dichotomie avec essais successifs de différents retards $\tau$ jusqu'à trouver une valeur satisfaisante du déphasage $\Phi_0$.

Une autre manière de procéder consiste en la mesure du temps de propagation $\tau p$ du signal de référence dans le circuit. La valeur du retard $\tau$ est ensuite choisie directement.

Une différence de phase ou déphasage $\Phi_0$ entre le signal d'excitation et la réponse à l'excitation du circuit en l'absence de rayonnement laser appliqué au circuit est alors fournie par le circuit 20, à l'étape 101. Ce déphasage $\Phi_0$ est ajusté de préférence à une valeur proche de +90° ou -90°. Dans ce cas, le signal en sortie du filtre 28 est sensiblement nul.

Pour la détermination du déphasage $\Phi_0$, le signal d'excitation retardé, illustré sur la figure 3A, et la réponse du circuit, illustrée sur la figure 3B, sont multipliés par le multiplicateur 26 pour obtenir le signal illustré sur la figure 3C. La différence de phase obtenue en sortie du filtre 28 est illustrée sur la figure 3D. Celle-ci est très légèrement négative dans l'exemple considéré.

A l'étape 102, le laser est commandé pour illuminer une région réduite du circuit de coordonnées X, Y. A l'étape 104, ces coordonnées sont enregistrées dans les moyens de stockage 40. Le circuit ainsi illuminé ou préalablement illuminé par le faisceau laser est excité à l'étape 106 par l'envoi du signal électrique d'excitation.

En présence du laser, la différence de phase ou déphasage $\Phi$ entre le signal d'excitation retardé et la réponse à l'excitation du circuit est fournie par le circuit 20, à l'étape 106.

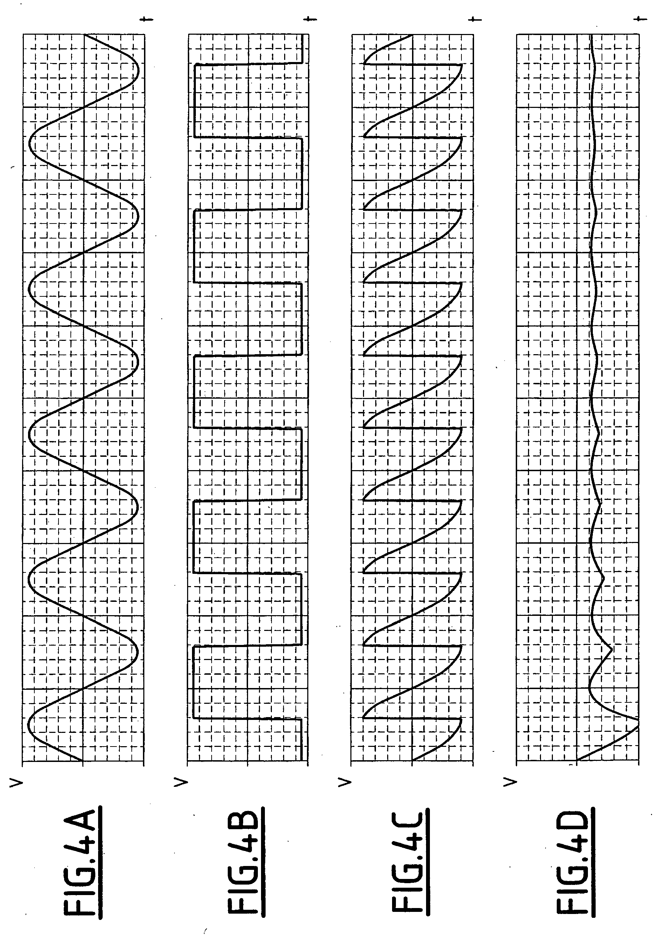

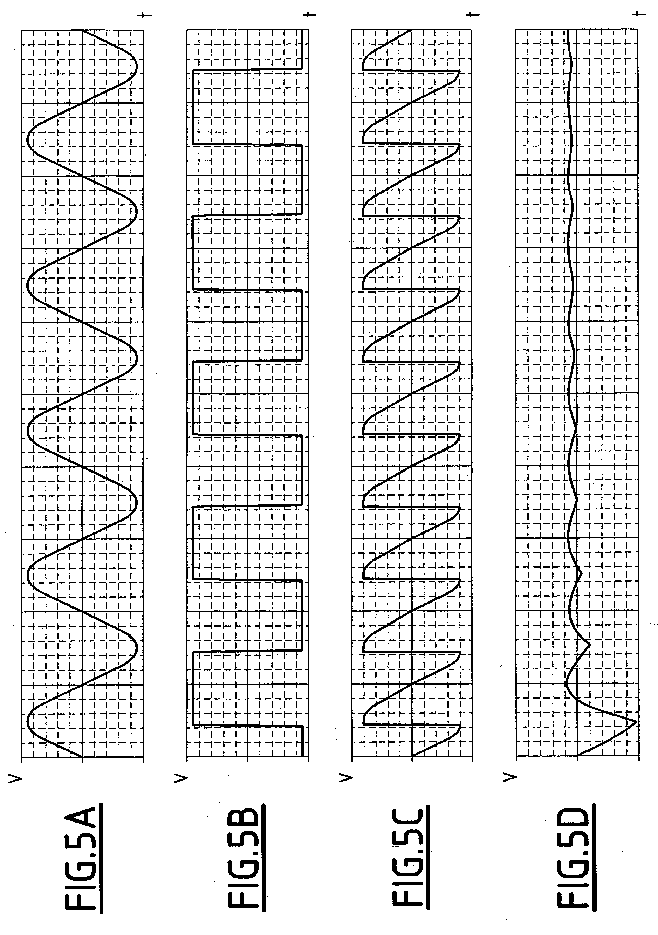

Dans le cas où l'action du laser conduit à un retard de la réponse du circuit, comme illustré sur la figure 4B comparée à la figure 3B, un retard de phase entre le signal est obtenu. La différence de phase obtenue en sortie du filtre 28 est illustrée sur la figure 4D. Dans le cas contraire où la réponse du circuit est avancée, comme illustré sur la figure 5B, une avance de phase entre les deux signaux est obtenue comme représenté sur les figures 5C et 5D.

Selon un premier mode de réalisation de l'invention, le faisceau laser est continu.

A l'étape 108, les triplets (X, Y, $\phi$) sont acquis pour chaque position de coordonnées X, Y. La création 44 d'une image se fait point par point alors que les triplets (X, Y, $\phi$) sont mémorisés dans les moyens de stockage 40.

Pour les étapes 102 à 108, suivant ce premier mode de réalisation, le rayonnement laser est appliqué sur une région réduite du circuit de manière simultané avec l'application de la séquence de test, de sorte que le circuit est illuminé au cours de la séquence de test.

Suivant un second mode de réalisation de l'invention, au contraire, le faisceau laser est pulsé avec des durées d'impulsions préférablement inférieures à la nanoseconde ou le faisceau laser est modulé avec des durées d'impulsions préférablement inférieures ou égales à la durée de la séquence de test appliquée au circuit. Le circuit est alors illuminé pendant des durées prédéterminées de la séquence de test.

Suivant le second mode de réalisation, la séquence de test est préférentiellement répétée plusieurs fois pour mesurer la variation du temps de propagation pour plusieurs moments différents de la séquence de test.

Suivant le second mode de réalisation, le faisceau laser est appliqué pendant une durée totale prédéterminée et suivant une zone réduite du circuit, soit de manière synchrone, soit de manière asynchrone avec l'application de la séquence de test.

Lorsque les applications sont dites synchrones, l'application du laser commence et se termine à des moments fixes et prédéterminés par rapport au début et à la fin de la séquence de test.

Lorsque les applications sont dites asynchrones, l'application du faisceau laser commence et se termine à des moments variables et aléatoires par rapport au début et à la fin des séquences de test.

Au cours du premier et second modes de réalisation, les étapes 102 à 108 sont répétées successivement pour différentes positions du point d'impact du faisceau laser suivant le circuit, de sorte que le laser balaie l'ensemble du circuit. A cet effet, à l'étape 110, il est vérifié si l'ensemble du circuit a été parcouru. Si tel n'est pas le cas, le laser est déplacé à l'étape 112 par les moyens 32, de sorte que le point d'impact soit légèrement déplacé puis les étapes 102 à 108 sont à nouveau mises en oeuvre. L'étape 112 est conduite de sorte que, par mise en oeuvre de la boucle, l'ensemble de la surface du circuit soit progressivement parcouru.

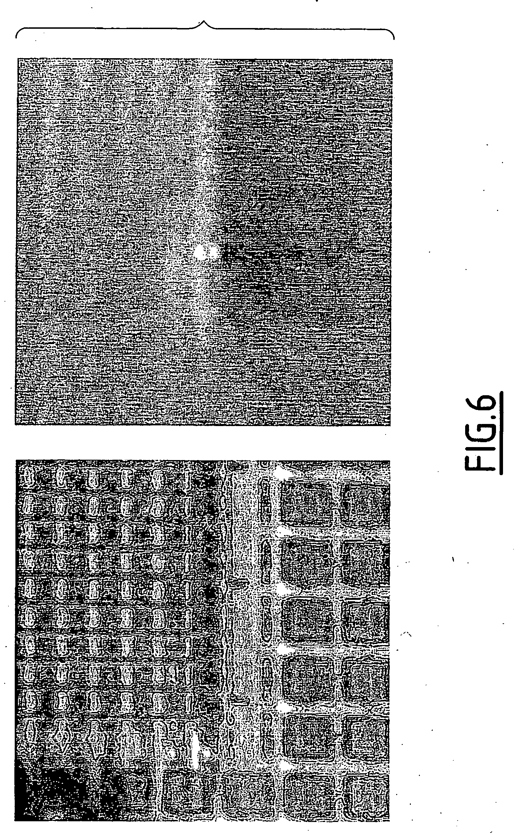

A l'étape 116, une image du circuit est produite par le dispositif de création d'image 44. Une telle imagé est illustrée sur la figure 6. Sur cette image, est illustrée la modification de différence de phase pour chacune des positions de coordonnées X, Y de sollicitation du faisceau laser.

Pour faciliter la visualisation des zones de défaut ou de faiblesse du circuit, une image en deux dimensions selon les axes X et Y, est extraite de l'image illustré sur la figure 6. Sur cette image en deux dimensions, les modifications du déphasage $\Phi$ sont colorisées selon différentes couleurs.

Cette image en deux dimensions est superposée à l'image optique du circuit référencé par les coordonnées X, Y. Cette image optique est obtenue à l'aide du laser 30 ou d'une caméra optique CCD.

La présence du faisceau laser en un point produit une modification ou une variation du déphasage. Celle-ci est particulièrement significative pour certaines zones du circuit. Cette variation peut être positive ou négative en fonction de l'effet du faisceau laser, de sorte que, pour certaines zones, la réponse est obtenue plus rapidement en présence du faisceau laser alors que, pour d'autres, la réponse est retardée. Dans certains cas, la variation va conduire à la propagation d'une information erronée dans le circuit. La réponse erronée du circuit sera elle aussi plus ou moins retardée ou avancée. Avantageusement la variation temporelle d'une réponse erronée pourra être observée sur une autre sortie du circuit.

Les zones où la variation de phase est importante apparaissent clairement sur l'image de la figure 6 et correspondent a priori à des régions du circuit qui comportent des défauts qui sont certes mineurs puisqu'ils ne sont pas de nature à faire que le circuit produise un résultat erroné mais qui peuvent s'avérer préjudiciables pour le circuit en cas de fonctionnement dans un environnement très contraint.

Le calcul du phasage étant obtenu par simple multiplication d'un signal de référence, ici le signal d'excitation par la réponse du circuit et par filtrage du signal produit obtenu, il n'est pas nécessaire de mettre en oeuvre un calcul complexe du décalage temporel qui peut s'avérer très délicat à établir.

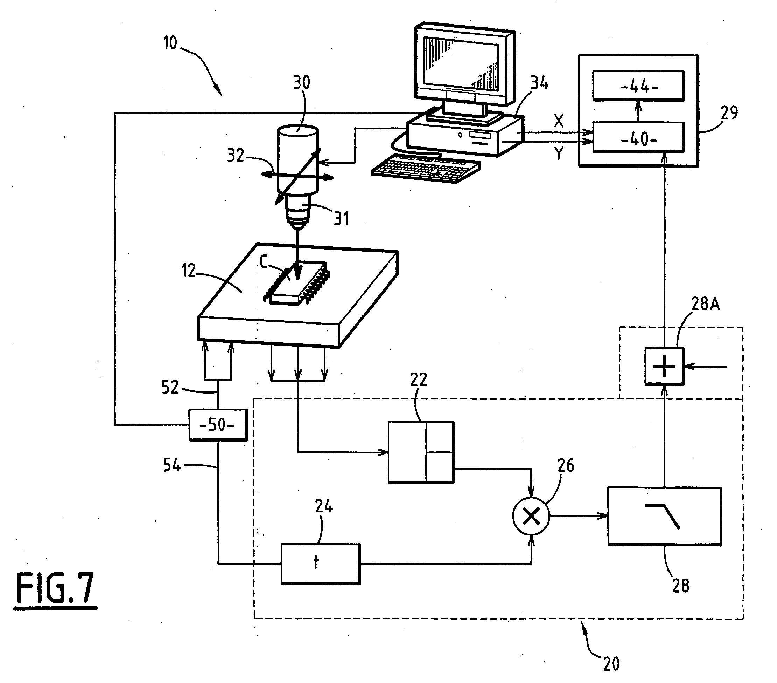

En variante et tel que représenté sur la figure 7, le générateur de fonction formant le générateur 16 de signaux d'excitation est remplacé par un testeur 50 propre à imposer une séquence de tests électriques prédéterminés au circuit intégré 16 à étudier et à fournir un signal de référence pour le circuit multiplicateur 26.

Dans ce mode de réalisation, le testeur 50 est propre à fournir la séquence de tests depuis une sortie 52, celle-ci étant appliquée directement au circuit. Sur une sortie 54, le testeur est propre à fournir un signal de référence correspondant au signal attendu en sortie du circuit en l'absence dé laser dans le cas d'un circuit fonctionnant normalement.

Ce signal de référence est obtenu par simulation du circuit suivant le premier mode de réalisation. Dans un second mode de réalisation, le signal de référence est obtenu par mesure directement sur un circuit fonctionnant normalement en l'absence de laser.

Dans le cadre de l'utilisation d'un testeur 50, la ligne à retard 24 est optionnelle, le retard pouvant être établi par le testeur lui-même.

Suivant le premier mode de réalisation, le signal de référence présente une fréquence et un rapport cyclique égal à celui du signal de sortie escompté pour le circuit fonctionnant normalement en l'absence de laser.

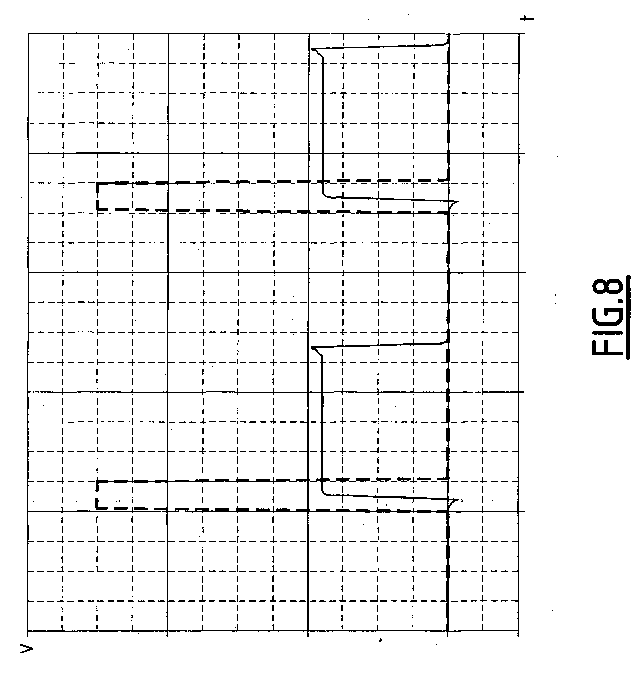

Avantageusement, et afin de permettre une analyse plus précise du seul front montant du signal de réponse du circuit, le signal de référence présente une fréquence identique à celle du signal de sortie attendu mais l'amplitude et/ou le rapport cyclique et/ ou la forme des impulsions des signaux est modifié. En particulier, la largeur des impulsions du signal de référence est réduite alors que son amplitude est augmentée comme illustré sur la figure 8.

Ainsi, le déphasage étant calculé par mise en oeuvre du produit du signal de référence par le signal de réponse du circuit, et ce produit correspondant à l'aire commune entre les deux courbes, le déphasage est extrêmement sensible à un retard ou une avance du front montant du signal, permettant ainsi une grande précision dans la détermination des variations de déphasage pouvant être induit par le rayonnement laser.

Par ailleurs, la différence de phase mesurée par le procédé selon l'invention dépend du déphasage relatif initial existant entre la réponse à l'excitation du circuit et la réponse de référence du circuit, à partir desquelles l'étape de mesure de la différence de phase est calculée.

La différence de phase obtenue par mise en oeuvre du procédé peut ainsi être soit le retard de phase, c'est-à-dire la différence de phases entre les fronts montants ou descendants des signaux en présence et en l'absence de rayonnements laser, soit la variation du rapport cyclique, c'est-à-dire l'évolution de la valeur moyenne du rapport cyclique du signal en présence et en l'absence de rayonnement laser.

En particulier, dans les installations décrites aux figures 1 et 7, en fixant à 0° le déphasage relatif initial entre la réponse à l'excitation du circuit alors que celui-ci n'est pas soumis à un rayonnement laser et la réponse de référence du circuit qui par définition est en l'absence de rayonnements laser appliqué au circuit, la différence de phase obtenue par mise en oeuvre du procédé est égale à la variation du rapport cyclique comme cela sera expliqué ultérieurement.

En revanche, si le déphasage relatif initial entre la réponse à l'excitation du circuit et la réponse de référence du circuit est fixée égale à 90°, la différence de phase obtenue par la mise en oeuvre du procédé est égale au retard de phase entre les fronts montants et descendants des signaux en l'absence et en présence de rayonnement laser.

En effet, dans le cas où les signaux d'excitation et de réponse de circuit sont périodiques, le signal peut être exprimé en tant que somme de fonctions sinusoïdales données par la transformation en séries de fourrier sous la forme :

$$V_{IC}(t) = a_o + \sum_{1}^{\infty} \left[ a_n \cos(n\varpi t) + b_n \sin(n\varpi t) \right]$$

$$a_o = \frac{1}{T} \int_0^T V_{IC}(t)\,dt$$

$$a_n = \frac{2}{T} \int_0^T V_{IC}(t)\cos(n\varpi t)\,dt$$

$$b_n = \frac{2}{T} \int_0^T V_{IC}(t)\sin(n\varpi t)\,dt .$$

Dans le cas où la réponse du circuit est un signal carré de rapport cyclique égal à 50% noté $V_{IC}$, la réponse de référence est un signal sinusoïdal notée V1, $V_{IC}$ peut s'écrire sous la forme $V_{IC}(t) = \sum_o^\infty [c_n \cos(n\omega + \theta_n)]$ où

$$c_n = \sqrt{a_n^2 + b_n^2} \; ; \text{ et}$$

$$\tan(\theta_n) = \frac{b_n}{a_n} .$$

A l'issue de la multiplication des deux signaux par l'étage 26, les deux signaux mixés, avant filtrage s'expriment sous la forme :

$$V_{IC}.V_1 = \sum_o^\infty [c_n \cos(n\varpi t - \theta_n)]\cos(\varpi t)$$

Après filtrage par le filtre $V_{OUT}$ passe bas, la sortie du filtre est seulement une fonction dépendante de la première harmonique s'exprimant sous la forme :

$$V_{OUT} = \frac{c_1}{2}\cos(-\theta_1)$$

Les expressions mentionnées ci-dessus sont supposées faites en l'absence d'altération due à la stimulation laser. Lorsque le circuit est soumis à un rayonnement laser, la réponse du circuit est modifiée en ce qui concerne ses harmoniques au niveau de la phase et de l'amplitude.
En considérant que la phase $\theta_1$ et l'amplitude $c_1$ sont légèrement modifiées autour des conditions initiales sous l'action du laser, des variations dc et dθ qui représentent respectivement des variations positives et négatives d'amplitude et de phase pour la première harmonique sont ajoutées de sorte que la sortie s'exprime sous la forme :

$$V_{OUT} = \frac{c_1 + dc}{2}\cos(-\theta_1 + d\theta) .$$

On comprend ainsi à partir de cette formule que la sortie dépend à la fois des conséquences du rayonnement laser à savoir dc et dθ et des conditions initiales imposées entre les deux entrées à savoir $c_1$ et dθ.
Ainsi, lorsque les deux entrées sont en phase (en l'absence de laser) la sortie du filtre est sensible essentiellement à la variation du rapport cyclique au travers de la valeur $c_1$.

Au contraire, lorsque le déphasage initial est égal à 90°, les deux signaux d'entrée sont en quadratures et la sortie du filtre est plus sensible au retard de phase à travers dθ.

En effet, dans chacune des conditions, les valeurs de sortie sont égales respectivement à

$$V_{OUT00°} = \frac{c_1 + dc}{2} cos(d\theta) \quad V_{OUT90°} = \frac{c_1 + dc}{2} sin(d\theta).$$

Sur la figure 8 est représentée une installation permettant d'obtenir simultanément le retard de phase et la variation de rapport cyclique dû à l'exposition du circuit à un rayonnement laser, sans qu'il soit nécessaire de régler le déphasage relatif initial à 0° et à 90°.

A cet effet, cette installation comporte les mêmes éléments que l'installation de la figure 1 auxquels d'autres éléments sont ajoutés.

En particulier, le circuit multiplicateur 26 et le filtre passe bas 28 forment un premier circuit détecteur de différence de phase noté 102. Un second circuit détecteur de différence de phase noté 104 identique est agencé dans l'unité de mesure 20. Celui-ci comporte, comme le circuit 102, un circuit multiplicateur 126 dont la sortie est reliée en entrée d'un filtre passe bas 128 identique au filtre 28. Le circuit multiplicateur 126 reçoit suivant une première entrée le signal issu de la sortie de l'unité de soustraction 22, c'est-à-dire le même signal d'entrée que le circuit 26.

Un dispositif 130 de déphasage de 90° est disposé entre la sortie de la ligne à retard 24 et la seconde entrée du circuit multiplicateur 26 de manière à appliquer en entrée du circuit 104 une réponse de référence déphasée de 90° par rapport à la réponse de référence appliquée au circuit 102.

Un circuit de décalage 128A est prévu en sortie du filtre 128 de manière analogue au circuit de décalage 28A.

Une unité de calcul 150 reçoit en entrée les signaux issus des deux circuits détecteurs de différence de phases 102 et 104 après que ceux-ci aient été retraités par le circuit de décalage 28A et 128A.

L'unité 150 est propre à calculer à partir des différences de phase reçues des deux circuits 102 et 104 le retard de phase dθ et la variation de rapport cyclique dc.

Pour ce faire, les sorties des circuits 102 et 104 fournissent des valeurs exprimées, respectivement pour les circuits 102 et 104 sous la forme :

$$V_{OUT} = \frac{c_1 + dc}{2} cos(\theta + d\theta)$$

$$V_{OUT(+90°)} = \frac{c_1 + dc}{2} sin(\theta + d\theta)$$

Le circuit 150 est propre à combiner ces deux expressions pour extraire les variations résultant de la stimulation laser pour le retard de phase dθ et pour le rapport cyclique *dc,* ceux-ci étant obtenus respectivement à partir des relations :

$$\frac{V_{OUT(+90°)}}{V_{OUT}} = tan(d\theta)$$

$$\sqrt{V_{OUT}^2 + V_{OUT(+90°)}^2} = \frac{c_1 + dc}{2}.$$

Ainsi, on constate que par mise en oeuvre de l'une ou l'autre des méthodes, les variations de rapport cyclique et le retard de phase peuvent être mesurés de manière simple fournissant ainsi des informations significatives sur les propriétés dynamiques du circuit intégré en test.

Comme précédemment, l'unité de traitement d'informations 29 assure un balayage de l'ensemble du circuit et une mise à disposition d'une cartographie du circuit permettant la mise à disposition des valeurs mesurées pour chacun des points du circuit.

**Revendications**

1. Procédé d'analyse d'un circuit intégré (C), comportant :

   - une étape (102) d'application d'un rayonnement laser en un point de la surface du circuit (C) ;
   - une étape (106) d'excitation du circuit (C) ainsi soumis au rayonnement laser par application d'un signal électrique d'excitation ;
   - une étape (106) de recueil de la réponse du circuit à l'excitation soumis au rayonnement laser ; **caractérisé par**
   - au moins une étape (106) de mesure de la différence de phase entre la réponse à l'excitation du circuit soumis au rayonnement laser et une réponse de référence du circuit en l'absence de rayonnement laser appliqué au circuit.

2. Procédé selon la revendication 1, **caractérisé en ce que** la réponse de référence est le signal d'excitation du circuit décalé temporairement par rapport à la réponse du circuit soumis au rayonnement laser d'un retard égal au temps de propagation du signal d'excitation au travers du circuit en l'absence de rayonnement laser.

3. Procédé selon la revendication 1, **caractérisé en ce que** la réponse de référence est un signal qui est fonction de la réponse attendue en sortie du circuit en l'absence de rayonnement laser.

4. Procédé selon la revendication 3, **caractérisé en ce que** la réponse de référence est égale à la réponse attendue en sortie du circuit fonctionnant normalement en l'absence de rayonnement.

5. Procédé selon la revendication 3, **caractérisé en ce que** la réponse de référence est une transformée de la réponse attendue en sortie du circuit en l'absence de rayonnement, de même fréquence et dont l'amplitude et/ ou la largeur des impulsions et/ ou la forme des impulsions ont été modifiées.

6. Procédé selon l'une quelconque des revendications précédentes, **caractérisé en ce que** la ou chaque étape de mesure du déphasage entre la réponse à l'excitation du circuit soumis au rayonnement laser et une réponse de référence du circuit en l'absence de rayonnement laser appliqué au circuit comprend :

   - la multiplication de la réponse à l'excitation du circuit soumis au rayonnement laser par la réponse de référence du circuit en l'absence de rayonnement laser appliqué au circuit ; et
   - la filtration du produit obtenu par un filtre passe bas.

7. Procédé selon l'une quelconque des revendications 1 à 6, **caractérisé en ce que** l'étape (106) de mesure de la différence de phase entre la réponse à l'excitation du circuit soumis au rayonnement laser et la réponse de référence du circuit en l'absence de rayonnement laser appliqué au circuit est effectuée par traitement des deux réponses qui, en l'absence de rayonnement laser, ont un déphasage relatif initial nul pour obtenir, en tant que différence de phase, la variation du rapport cyclique.

8. Procédé selon l'une quelconque des revendications 1 à 6, **caractérisé en ce que** l'étape (106) de mesure de la différence de phase entre la réponse à l'excitation du circuit soumis au rayonnement laser et la réponse de référence du circuit en l'absence de rayonnement laser appliqué au circuit est effectuée par traitement des deux réponses considérées toutes deux en l'absence de rayonnement laser avec un déphasage relatif égal à 90° pour obtenir, en tant que différence de phase, le retard de phase.

9. Procédé selon l'une quelconque des revendications 1 à 6, **caractérisé en ce qu'**il comporte en plus de l'étape (106) de mesure de la différence de phase entre la réponse à l'excitation du circuit soumis au rayonnement laser et une réponse de référence du circuit en l'absence de rayonnement laser appliqué au circuit :

   - une étape supplémentaire de mesure de la différence de phase supplémentaire entre la réponse à l'excitation du circuit soumis au rayonnement laser et la réponse de référence du circuit en l'absence de rayonnement laser appliqué au circuit décalée d'une différence de phase supplémentaire prédéterminée ; et
   - une étape de calcul du retard de phase et de la variation de rapport cyclique entre la réponse à l'excitation du circuit soumis au rayonnement laser et la réponse de référence du circuit en l'absence de rayonnement laser appliqué au circuit à partir de ladite différence de phase mesurée et de ladite différence de phase supplémentaire mesurée.

**10.** Procédé selon la revendication 9, **caractérisé en ce que** ladite différence de phase supplémentaire prédéterminée est égale à 90°.

**11.** Procédé d'observation d'un circuit intégré (C), **caractérisé en ce qu'**il comporte :

- pour une pluralité de points (X, Y) à la surface du circuit intégré, une étape (102, 106) d'analyse du circuit selon l'une quelconque des revendications précédentes pour la détermination de la différence de phase entre la réponse à l'excitation du circuit soumis au rayonnement laser en un point (X, Y) de la surface du circuit intégré (C) et une réponse de référence du circuit en l'absence de rayonnement laser appliqué au circuit ; et
- une étape (108) de création d'une image du circuit intégré (C) illustrant une valeur représentative de la différence de phase entre la réponse à l'excitation du circuit soumis au rayonnement laser et la réponse de référence du circuit en l'absence de rayonnement laser appliqué au circuit pour chaque point d'application (X, Y) du rayonnement laser.

**12.** Procédé selon l'une quelconque des revendications précédentes, **caractérisé en ce que** le rayonnement laser a une longueur d'onde comprise entre 800 nm et 1400 nm.

**13.** Procédé selon la revendication 12, **caractérisé en ce que** la longueur d'onde du rayonnement laser est choisie dans le groupe consistant en 1064 nm et 1340 nm.

**14.** Procédé selon l'une quelconque des revendications précédentes, **caractérisé en ce que** le rayonnement laser est appliqué en chaque point (X, Y) de manière synchrone avec l'étape (106) d'excitation du circuit.

**15.** Procédé selon l'une quelconque des revendications 1 à 13, **caractérisé en ce que** le rayonnement laser est appliqué en chaque point (X, Y) de manière asynchrone avec l'étape (106) d'excitation du circuit.

**16.** Procédé selon l'une quelconque des revendications précédentes, **caractérisé en ce que** le rayonnement laser est pulsé avec au moins une impulsion en chaque point (X, Y) du circuit.

**17.** Installation d'analyse comportant :

- des moyens (30) d'application d'un rayonnement laser en un point de la surface d'un circuit intégré (C) ;
- des moyens (16, 18 ; 50) d'excitation du circuit (C) ainsi soumis au rayonnement laser par application d'un signal électrique d'excitation ;
- des moyens (22) de recueil de la réponse du circuit à l'excitation soumis au rayonnement laser ;
- des moyens (16, 24 ; 50) pour fournir une réponse de référence du circuit en l'absence de rayonnement laser appliqué au circuit ; et **caractérisé par**
- des moyens (26, 28) de mesure de la différence de phase entre la réponse à l'excitation du circuit soumis au rayonnement laser et la réponse de référence du circuit en l'absence de rayonnement laser appliqué au circuit.

**18.** Installation d'analyse selon la revendication 17, **caractérisée en ce que** les moyens (26, 28) de mesure de la différence de phase entre la réponse à l'excitation du circuit soumis au rayonnement laser et la réponse de référence du circuit en l'absence de rayonnement laser appliqué au circuit comprennent des moyens pour effectuer le traitement des deux réponses qui, en l'absence de rayonnement laser, ont un déphasage relatif initial nul pour obtenir, en tant que différence de phase, la variation du rapport cyclique.

**19.** Installation d'analyse selon la revendication 17, **caractérisée en ce que** les moyens (26, 28) de mesure de la différence de phase entre la réponse à l'excitation du circuit soumis au rayonnement laser et la réponse de référence du circuit en l'absence de rayonnement laser appliqué au circuit comprennent des moyens pour effectuer le traitement des deux réponses qui, en l'absence de rayonnement laser, ont un déphasage relatif égal à 90°, pour obtenir, ne tant que différence de phase, le retard de phase.

**20.** Installation d'analyse selon la revendication 17, **caractérisée en ce qu'**elle comporte en plus des moyens (26, 28) de mesure de la différence de phase entre la réponse à l'excitation du circuit soumis au rayonnement laser et une réponse de référence du circuit en l'absence de rayonnement laser appliqué au circuit :

- des moyens supplémentaires (126, 128, 130) de mesure de la différence de phase supplémentaire entre la réponse à l'excitation du circuit soumis au rayonnement laser et la répons de référence du circuit en l'absence de rayonnement laser appliqué au circuit décalée d'une différence de phase supplémentaire prédéterminée ; et
- des moyens (150) de calcul du retard de phase et de la variation de rapport cyclique entre la réponse à l'excitation du circuit soumis au rayonnement laser et la réponse de référence du circuit en l'absence de rayonnement laser appliqué au circuit à partir de ladite différence de phase mesurée et de ladite différence de phase supplémentaire mesurée.

**21.** Installation selon la revendication 20, **caractérisée en ce que** ladite différence de phase supplémentaire prédéterminée est égale à 90°.

**22.** Installation d'observation **caractérisée en ce qu'**elle comporte :

- pour une pluralité de points (X, Y) à la surface d'un circuit intégré, une installation d'analyse du circuit selon la revendication 17 pour la détermination de la différence de phase entre la réponse à l'excitation du circuit soumis au rayonnement laser en un point (X, Y) de la surface du circuit intégré (C) et une réponse de référence du circuit en l'absence de rayonnement laser appliqué au circuit ; et
- des moyens (29) de création d'une image du circuit intégré (C) illustrant une valeur représentative de la différence de phase entre la réponse à l'excitation du circuit soumis au rayonnement laser et la réponse de référence du circuit en l'absence de rayonnement laser appliqué au circuit pour chaque point d'application (X, Y) du rayonnement laser.

**Patentansprüche**

**1.** Verfahren zur Analyse eines integrierten Schaltkreises (C), aufweisend:

- einen Schritt (102) zum Anwenden einer Laserstrahlung an einen Punkt auf der Oberfläche des Schaltkreises (C);
- einen Schritt (106) zum Anregen des Schaltkreises (C), welcher so der Laserstrahlung ausgesetzt ist, mittels Anlegen eines elektrischen Anregungssignals;
- einen Schritt (106) zum Erfassen der Antwort des Schaltkreises, welcher der Laserstrahlung ausgesetzt ist, auf die Anregung;

**gekennzeichnet durch**

- mindestens einen Schritt (106) zum Messen der Phasendifferenz zwischen der Antwort auf die Anregung des Schaltkreises, welcher der Laserstrahlung ausgesetzt ist, und einer Referenzantwort des Schaltkreises in Abwesenheit von an den Schaltkreis angelegter Laserstrahlung.

**2.** Verfahren nach Anspruch 1, **dadurch gekennzeichnet, dass** die Referenzantwort das Anregungssignal des Schaltkreises ist, welches in Bezug auf die Antwort des Schaltkreises, welcher der Laserstrahlung ausgesetzt ist, mit einer Verzögerung gleich der Laufzeit des Anregungssignals durch den Schaltkreis in Abwesenheit von Laserstrahlung zeitweise versetzt ist.

**3.** Verfahren nach Anspruch 1, **dadurch gekennzeichnet, dass** die Referenzantwort ein Signal ist, welches von der am Ausgang erwarteten Antwort des Schaltkreises in Abwesenheit von Laserstrahlung abhängig ist.

**4.** Verfahren nach Anspruch 3, **dadurch gekennzeichnet, dass** die Referenzantwort gleich der am Ausgang erwarteten Antwort des in Abwesenheit von Strahlung normal funktionierenden Schaltkreises ist.

**5.** Verfahren nach Anspruch 3, **dadurch gekennzeichnet, dass** die Referenzantwort eine Transformation der am Ausgang erwarteten Antwort des Schaltkreises in Abwesenheit von Strahlung von gleicher Frequenz ist, deren Amplitude und / oder deren Pulsbreite und / oder deren Pulsform geändert wurden.

**6.** Verfahren nach einem der vorhergehenden Ansprüche, **dadurch gekennzeichnet, dass** der oder jeder Schritt des Messens der Phasendifferenz zwischen der Antwort auf die Anregung des Schaltkreises, welcher der Laserstrahlung ausgesetzt ist, und einer Referenzantwort des Schaltkreises in Abwesenheit von an den Schaltkreis angelegter Laserstrahlung aufweist:

- Multiplizieren der Antwort auf die Anregung des Schaltkreises, welcher der Laserstrahlung ausgesetzt ist, mit der Referenzantwort des Schaltkreises in Abwesenheit von an den Schaltkreis angelegter Laserstrahlung; und
- Filtern des erhaltenen Produkts durch ein Tiefpassfilter.

7. Verfahren nach einem der Ansprüche 1 bis 6, **dadurch gekennzeichnet, dass** der Schritt (106) zum Messen der Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung mittels Verarbeitung der beiden Antworten erfolgt, welche in Abwesenheit von Laserstrahlung eine anfängliche relative Phasenverschiebung von Null aufweisen, um, als Phasendifferenz, die Änderung des Taktverhältnisses zu erhalten.

8. Verfahren nach einem der Ansprüche 1 bis 6, **dadurch gekennzeichnet, dass** der Schritt (106) zum Messen der Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung mittels Verarbeitung der beiden Antworten erfolgt, wobei beide in Abwesenheit von Laserstrahlung mit einer relativen Phasenverschiebung gleich 90° betrachtet werden, um, als Phasendifferenz, die Phasenverzögerung zu erhalten.

9. Verfahren nach einem der Ansprüche 1 bis 6, **dadurch gekennzeichnet, dass** es zusätzlich zu dem Schritt (106) zum Messen der Phasendifferenz zwischen der Antwort auf die Anregung des Schaltkreises, welcher der Laserstrahlung ausgesetzt ist, und einer Referenzantwort des Schaltkreises in Abwesenheit von an den Schaltkreis angelegter Laserstrahlung aufweist:

    - einen zusätzlichen Schritt des Messens der zusätzlichen Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung versetzt um eine zusätzliche vorbestimmte Phasendifferenz und
    - einen Schritt des Berechnens der Phasenverzögerung und der Änderung des Taktverhältnisses zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung, ausgehend von der gemessenen Phasendifferenz und der gemessenen zusätzlichen Phasendifferenz.

10. Verfahren nach Anspruch 9, **dadurch gekennzeichnet, dass** die vorbestimmte zusätzliche Phasendifferenz gleich 90° ist.

11. Verfahren zum Beobachten eines integrierten Schaltkreises (C), **dadurch gekennzeichnet, dass** es aufweist:

    - für eine Mehrzahl von Punkten (X, Y) auf der Oberfläche des integrierten Schaltkreises einen Schritt (102, 106) der Analyse des Schaltkreises nach einem der vorhergehenden Ansprüche zur Bestimmung der Phasendifferenz zwischen der Antwort auf die Anregung des Schaltkreises, welcher der Laserstrahlung ausgesetzt ist, an einem Punkt (X, Y) der Oberfläche des integrierten Schaltkreises (C) und einer Referenzantwort des Schaltkreises in Abwesenheit von an den Schaltkreis angelegter Laserstrahlung und
    - einen Schritt (108) zum Erzeugen eines Bildes des integrierten Schaltkreises (C), welches einen Wert darstellt, welcher für die Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung für jeden Anwendungspunkt (X, Y) der Laserstrahlung repräsentativ ist.

12. Verfahren nach einem der vorhergehenden Ansprüche, **dadurch gekennzeichnet, dass** die Laserstrahlung eine Wellenlänge zwischen 800 nm und 1400 nm hat.

13. Verfahren nach Anspruch 12, **dadurch gekennzeichnet, dass** die Wellenlänge der Laserstrahlung aus der Gruppe bestehend aus 1064 nm und 1340 nm ausgewählt ist.

14. Verfahren nach einem der vorhergehenden Ansprüche, **dadurch gekennzeichnet, dass** die Laserstrahlung an jedem Punkt (X, Y) synchron mit dem Schritt (106) des Anregens des Schaltkreises angewendet wird.

15. Verfahren nach einem der Ansprüche 1 bis 13, **dadurch gekennzeichnet, dass** die Laserstrahlung an jedem Punkt (X, Y) asynchron zu dem Schritt (106) des Anregens des Schaltkreises angewendet wird.

**16.** Verfahren nach einem der vorhergehenden Ansprüche, **dadurch gekennzeichnet, dass** die Laserstrahlung mit mindestens einem Puls an jedem Punkt (X, Y) des Schaltkreises gepulst wird.

**17.** Einrichtung zur Analyse aufweisend:

- Mittel (30) zum Anwenden einer Laserstrahlung an einem Punkt auf der Oberfläche eines integrierten Schaltkreises (C),
- Mittel (16, 18; 50) zum Anregen des Schaltkreises (C), welcher der Laserstrahlung so ausgesetzt ist, mittels Anlegen eines elektrischen Anregungssignals,
- Mittel (22) zum Erfassen der Antwort des Schaltkreises, welcher der Laserstrahlung ausgesetzt ist, auf die Anregung,
- Mittel (16, 24; 50) zum Bereitstellen einer Referenzantwort des Schaltkreises in Abwesenheit von an den Schaltkreis angelegter Laserstrahlung, und **gekennzeichnet durch**
- Mittel (26, 28) zum Messen der Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung.

**18.** Einrichtung zur Analyse nach Anspruch 17, **dadurch gekennzeichnet, dass** die Mittel (26, 28) zum Messen der Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung Mittel zum Durchführen der Verarbeitung der beiden Antworten aufweisen, welche in Abwesenheit von Laserstrahlung eine anfängliche relative Phasenverschiebung von Null aufweisen, um, als Phasendifferenz, die Änderung des Taktverhältnisses zu erhalten.

**19.** Einrichtung zur Analyse nach Anspruch 17, **dadurch gekennzeichnet, dass** die Mittel (26, 28) zum Messen der Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung Mittel zum Durchführen der Verarbeitung der beiden Antworten aufweisen, welche in Abwesenheit von Laserstrahlung eine relative Phasenverschiebung gleich 90° aufweisen, um, als Phasendifferenz, die Phasenverzögerung zu erhalten.

**20.** Einrichtung zur Analyse nach Anspruch 17, **dadurch gekennzeichnet, dass** sie zusätzlich zu den Mittel (26, 28) zum Messen der Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung aufweist:

- zusätzliche Mittel (126, 128, 130) zum Messen der zusätzlichen Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung, versetzt um eine zusätzliche vorbestimmte Phasendifferenz und
- Mittel (150) zum Berechnen der Phasenverzögerung und der Änderung des Taktverhältnisses zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung, ausgehend von der gemessenen Phasendifferenz und der gemessenen zusätzlichen Phasendifferenz.

**21.** Einrichtung nach Anspruch 20, **dadurch gekennzeichnet, dass** die vorbestimmte zusätzliche Phasendifferenz gleich 90° ist.

**22.** Einrichtung zum Beobachten, **dadurch gekennzeichnet, dass** sie aufweist:

- für eine Mehrzahl von Punkten (X, Y) auf der Oberfläche eines integrierten Schaltkreises eine Einrichtung zur Analyse des Schaltkreises nach Anspruch 17 zur Bestimmung der Phasendifferenz zwischen der Antwort auf die Anregung des Schaltkreises, welcher der Laserstrahlung ausgesetzt ist, an einem Punkt (X, Y) der Oberfläche des integrierten Schaltkreises (C) und einer Referenzantwort des Schaltkreises in Abwesenheit von an den Schaltkreis angelegter Laserstrahlung und
- Mittel (29) zum Erzeugen eines Bildes des integrierten Schaltkreises (C), welcher einen Wert darstellt, welcher für die Phasendifferenz zwischen der Antwort auf die Anregung des Schaltkreises, welcher der Laserstrahlung ausgesetzt ist, und der Referenzantwort des Schaltkreises in Abwesenheit von an den Schaltkreis angelegter Laserstrahlung für jeden Anwendungspunkt (X, Y) der Laserstrahlung repräsentativ ist.

**Claims**

1. A method for analyzing an integrated circuit (C), including:

   - a step (102) for applying laser radiation at a point on the surface of the circuit (C);
   - a step (106) for exciting the circuit (C) thus subjected to laser radiation by applying an electrical excitation signal;
   - a step (106) for collecting the response of the circuit to the excitation, the circuit being subjected to laser radiation; **characterized by**
   - at least one step (106) for measuring the phase difference between the response to the excitation of the circuit subjected to laser radiation and a reference response of the circuit in the absence of laser radiation applied to the circuit.

2. A method according to Claim 1, **characterized in that** the reference response is the excitation signal of the circuit shifted temporarily with respect to the response of the circuit subjected to laser radiation by a delay equal to the propagation time of the excitation signal through the circuit in the absence of laser radiation.

3. A method according to Claim 1, **characterized in that** the reference response is a signal which is a function of the response expected at the output of the circuit in the absence of laser radiation.

4. A method according to Claim 3, **characterized in that** the reference response is equal to the response expected at the output of the circuit operating normally in the absence of radiation.

5. A method according to Claim 3, **characterized in that** the reference response is a transform of the response expected at the output of the circuit in the absence of radiation, of the same frequency, and for which the amplitude and/or the pulse width and/or the shape of pulses have been modified.

6. A method according to any one of the preceding claims, **characterized in that** the or each step for measuring the phase shift between the response to the excitation of the circuit subjected to laser radiation and a reference response of the circuit in the absence of laser radiation applied to the circuit comprises:

   - multiplying the response to the excitation of the circuit subjected to laser radiation by the reference response of the circuit in the absence of laser radiation applied to the circuit; and
   - filtering the product obtained through a low-pass filter.

7. A method according to any one of Claims 1 to 6, **characterized in that** the step (106) for measuring the phase difference between the response to the excitation of the circuit subjected to laser radiation and the reference response of the circuit in the absence of laser radiation applied to the circuit is carried out by processing both responses which, in the absence of laser radiation, have a zero initial relative phase shift, in order to obtain, as phase difference, the variation in the duty cycle.

8. A method according to any one of Claims 1 to 6, **characterized in that** the step (106) for measuring the phase difference between the response to the excitation of the circuit subjected to laser radiation and the reference response of the circuit in the absence of laser radiation applied to the circuit is carried out by processing both responses, both of which are considered in the absence of laser radiation with a relative phase shift equal to 90°, in order to obtain, as phase difference, the phase delay.

9. A method according to any one of Claims 1 to 6, **characterized in that** it comprises in addition to the step (106) for measuring the phase difference between the response to the excitation of the circuit subjected to laser radiation and a reference response of the circuit in the absence of laser radiation applied to the circuit:

   - an additional step for measuring the additional phase difference between the response to the excitation of the circuit subjected to laser radiation and the reference response of the circuit in the absence of laser radiation applied to the circuit and shifted by a predetermined additional phase difference; and
   - a step for calculating the phase delay and the variation in duty cycle between the response to the excitation of the circuit subjected to laser radiation and the reference response of the circuit in the absence of laser radiation applied to the circuit from said measured phase difference and said measured additional phase difference.

10. A method according to Claim 9, **characterized in that** said predetermined additional phase difference is equal to 90°.

11. A method for observing an integrated circuit (C), **characterized in that** it includes:

- for a plurality of points (X, Y) on the surface of the integrated circuit, a step (102, 106) for analyzing the circuit according to any one of the preceding claims for the determination of the phase difference between the response to the excitation of the circuit subjected to laser radiation at a point (X, Y) on the surface of the integrated circuit (C) and a reference response of the circuit in the absence of laser radiation applied to the circuit; and
- a step (108) for creating an image of the integrated circuit (C) illustrating a value representing the phase difference between the response to the excitation of the circuit subjected to laser radiation and the reference response of the circuit in the absence of laser radiation applied to the circuit for each point of application (X, Y) of the laser radiation.

12. A method according to any one of the preceding claims, **characterized in that** the laser radiation has a wavelength of between 800 nm and 1400 nm.

13. A method according to Claim 12, **characterized in that** the laser radiation wavelength is chosen to be in the group consisting of 1064 nm and 1340 nm.

14. A method according to any one of the preceding claims, **characterized in that** the laser radiation is applied at each point (X, Y) synchronously with the circuit excitation step (106).

15. A method according to any one of Claims 1 to 13, **characterized in that** the laser radiation is applied at each point (X, Y) asynchronously with the circuit excitation step (106).

16. A method according to any one of the preceding claims, **characterized in that** the laser radiation is pulsed with at least one pulse at each point (X, Y) on the circuit.

17. An analysis installation including:

- means (30) for applying laser radiation at a point on the surface of an integrated circuit (C);
- means (16, 18; 50) for exciting the circuit (C) thus subjected to laser radiation by applying an electrical excitation signal;
- means (22) for collecting the response of the circuit to the excitation, the circuit being subjected to laser radiation;
- means (16, 24; 50) for providing a reference response of the circuit in the absence of laser radiation applied to the circuit; and **characterized by**
- means (26, 28) for measuring the phase difference between the response to the excitation of the circuit subjected to laser radiation and the reference response of the circuit in the absence of laser radiation applied to the circuit.

18. An analysis installation according to Claim 17, **characterized in that** the means (26, 28) for measuring the phase difference between the response to the excitation of the circuit subjected to laser radiation and the reference response of the circuit in the absence of laser radiation applied to the circuit comprise means for carrying out the processing of both responses which, in the absence of laser radiation, have a zero initial relative phase shift, in order to obtain, as phase difference, the variation in the duty cycle.

19. An analysis installation according to Claim 17, **characterized in that** the means (26, 28) for measuring the phase difference between the response to the excitation of the circuit subjected to laser radiation and the reference response of the circuit in the absence of laser radiation applied to the circuit comprise means for carrying out the processing of both responses which, in the absence of laser radiation, have a relative phase shift equal to 90°, in order to obtain, as phase difference, the phase delay.

20. An analysis installation according to Claim 17, **characterized in that** it includes, in addition to the means (26, 28) for measuring the phase difference between the response to the excitation of the circuit subjected to laser radiation and a reference response of the circuit in the absence of laser radiation applied to the circuit:

- additional means (126, 128, 130) for measuring the additional phase difference between the response to the excitation of the circuit subjected to laser radiation and the reference response of the circuit in the absence of laser radiation applied to the circuit shifted by a predetermined additional phase difference; and
- means (150) for calculating the phase delay and the variation in duty cycle between the response to the excitation of the circuit subjected to laser radiation and the reference response of the circuit in the absence of laser radiation applied to the circuit from said measured phase difference and said measured additional phase difference.

21. An installation according to Claim 20, **characterized in that** said predetermined additional phase difference is equal to 90°.

22. An observation installation **characterized in that** it includes:

- for a plurality of points (X, Y) on the surface of an integrated circuit, an installation for analyzing the circuit according to Claim 17 for the determination of the phase difference between the response to the excitation of the circuit subjected to laser radiation at a point (X, Y) on the surface of the integrated circuit (C) and a reference response of the circuit in the absence of laser radiation applied to the circuit; and
- means (29) for creating an image of the integrated circuit (C) illustrating a value representing the phase difference between the response to the excitation of the circuit subjected to laser radiation and the reference response of the circuit in the absence of laser radiation applied to the circuit for each point of application (X, Y) of the laser radiation.

FIG.1

Ajustement du déphasage
en l'absence de laser ⎯⎯ 100

Obtention du déphasage
en l'absence de laser Φ0 ⎯⎯ 101

Laser en (X,Y) ⎯⎯ 102

Enregistrement
position ⎯⎯ 104

112

Incrémentation (X,Y)

Obtention du déphasage
en présence de laser Φ ⎯⎯ 106

Acquisition des triplets (X,Y,Φ) et
visualisation point par point de l'image ⎯⎯ 108

⎯⎯ 110

Non ◁⎯⎯⎯⎯ Circuit parcouru ?

Oui

Image du déphasage
induit par le laser ⎯⎯ 116

# FIG.2

FIG.3A

FIG.3B

FIG.3C

FIG.3D

EP 2 029 399 B1

FIG.4A

FIG.4B

FIG.4C

FIG.4D

FIG.5A

FIG.5B

FIG.5C

FIG.5D

FIG.6

## FIG.7

FIG.8

FIG.9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6483322 B
- US 4698587 A
- FR 2876188